# EUROPÄISCHE PATENTANMELDUNG

(11) **EP 4 303 033 A1**
(43) Veröffentlichungstag der Anmeldung: **10.01.2024**
(21) Anmeldenummer: 22183153.0
(22) Anmeldetag: 05.07.2022
(51) Int. Cl.: B60B 7/00, B60B 7/04, C23C 14/02, C23C 14/20, B05D 5/06

(54) **BESCHICHTETES FORMTEIL UND ENTSPRECHENDES HERSTELLUNGSVERFAHREN**

(71) Anmelder: Ulbrichts GmbH, 4690 Schwanenstadt (AT)
(72) Erfinder: SCHARPENACK, Georg, 4813 Altmünster (AT); SIMONET, Jules Franz Thierry, 8045 Graz (AT)
(74) Vertreter: Bardehle Pagenberg Partnerschaft mbB Patentanwälte Rechtsanwälte

(57) **Zusammenfassung**

Die vorliegende Erfindung betrifft ein Formteil, aufweisend: (a.) zumindest ein Kunststoffsubstrat, welches eine Oberflächentextur mit einer Tiefe von 0,005 bis 0,2 mm aufweist; und (b.) eine auf das Kunststoffsubstrat mittels Dünnschichtverfahren, im speziellen physikalischer Gasphasenabscheidung (Physical Vapor Deposition, PVD), aufgebrachte metallische Beschichtung, welche die Oberflächentextur zumindest teilweise bedeckt und welche eine Dicke von 0,1 bis 1,0 µm aufweist. Die Erfindung betrifft außerdem ein Herstellungsverfahren für ein solches Formteil.

## Beschreibung

### 1. Technisches Gebiet

Die vorliegende Erfindung betrifft ein Formteil für die Verwendung beispielsweise im Automobilbau und ein entsprechendes Herstellungsverfahren.

### 2. Stand der Technik

Insbesondere im Automobilbau ist die Verwendung von Kunststoffformteilen bekannt. Diese sind relativ einfach und kostengünstig herzustellen und führen aufgrund ihrer geringen Dichte zu einer Reduktion des Fahrzeuggewichts. Beispielsweise werden Kraftfahrzeuge, insbesondere elektrisch betriebene Fahrzeuge, inzwischen häufig mit sogenannten Aerorädern ausgestattet. Diese weisen zwischen den Felgenstreben Abdeckungen (sogenannte Radeinleger) auf, welche die Aerodynamik des Rades verbessern. Die Abdeckungen sind häufig am Rand der Felge angeordnet, da sie dort ihre größte Wirkung entfalten. Kunststoffformteile werden aber auch an anderen Stellen von Kraftfahrzeugen und in anderen Industriezweigen verwendet.

Kunststoffformteile, wie sie im Stand der Technik bekannt sind, weisen häufig eine nachteilige Optik und Haptik auf. Das gilt insbesondere dann, wenn Kunststoffformteile in unmittelbarer Nähe zu metallischen Teilen, wie beispielsweise Aluminium, Stahl, etc. platziert werden. Kunststoff hat im Vergleich zu Metall eine andere Oberflächenbeschaffenheit, welche sich in einer gegenüber Metall als minderwertig empfundenen Optik und Haptik widerspiegelt. Beispielsweise springt bei den bereits angesprochenen Aerorädern die Kombination unterschiedlicher Materialien (Leichtmetall und Kunststoff) sofort ins Auge.

Der vorliegenden Erfindung liegt daher die Aufgabe zugrunde, ein Formteil und ein entsprechendes Herstellungsverfahren anzugeben, welche die erwähnten Nachteile des Stands der Technik ausräumen. Insbesondere soll ein Formteil mit einer verbesserten Optik und Haptik bereitgestellt werden.

### 3. Zusammenfassung der Erfindung

Diese Aufgabe wird durch den Gegenstand der unabhängigen Ansprüche gelöst.

Ein erster Aspekt der vorliegenden Erfindung betrifft Formteil, aufweisend: (a.) zumindest ein Kunststoffsubstrat, welches eine Oberflächentextur mit einer Tiefe von 0,005 bis 0,2 mm aufweist; (b.) eine auf das Kunststoffsubstrat mittels Dünnschichtverfahren, im speziellen physikalischer Gasphasenabscheidung (Physical Vapor Deposition, PVD), aufgebrachte metallische Beschichtung, welche die Oberflächentextur zumindest teilweise bedeckt und welche eine Dicke von 0,1 bis 1,0 µm aufweist.

Da erfindungsgemäße Formteil weist gegenüber Formteilen im Stand der Technik eine wesentlich verbesserte Optik und Haptik auf. Aufgrund der relativ dünnen metallischen Beschichtung ist die darunterliegende Oberflächentextur des Kunststoffsubstrats sicht- und fühlbar. Diese fühl- und sichtbare Oberflächentextur kommt den Oberflächenstrukturen von Metallen, wie sie beispielsweise in Automobilen anzutreffen sind, so nahe, dass praktisch kein sicht- und fühlbarer Unterschied besteht. Ein erfindungsgemäßes Formteil wird daher insbesondere in unmittelbarer Nähe zu Metallteilen nicht als Fremdkörper empfunden.

Erfindungsgemäß ist die metallische Beschichtung im Vergleich zu gängigen Beschichtungen sehr dünn. Beispielweise beträgt die Schichtdicke von Lacken üblicherweise 25-40 µm. Die Schichtdicke bei metallisch galvanisiertem verchromtem Kunststoff bewegt sich in einer ähnlichen Größenordnung. Durch die erfindungsgemäß geringe Schichtdicke der metallischen Beschichtung ist die darunterliegende Oberflächentextur des Kunststoffsubstrats sicht- und fühlbar. Dadurch kann die Oberflächenstruktur derjenigen von bearbeitetem Metall nachempfunden werden.

Ein weiterer Vorteil der Erfindung besteht darin, dass das Kunststoffformteil - anders als Teile, die mittels Umformverfahren hergestellt werden - in nahezu beliebige Form gebracht werden kann. Beispielweise kann dieses mittels Spritzgussverfahren hergestellt werden, so dass nahezu beliebige Formen möglich sind. Trotzdem erhält das Formteil durch seine Oberflächentextur und die relativ dünne metallische Beschichtung ein wertiges Aussehen.

Die Tiefe der Oberflächentextur des Kunststoffsubstrats kann weiter bevorzugt 0,005 bis 0,1 mm betragen. Die Dicke der metallischen Beschichtung kann weiter bevorzugt 0,1 bis 0,6 µm betragen. Aufgrund der relativ geringen Dicke der metallischen Beschichtung kommt die Oberflächentextur selbst bei geringerer Tiefe zur Geltung.

Bei dem erfindungsgemäßen Formteil kann es sich um einen Radeinleger handeln. Wie bereits erläutert, werden Radeinleger z.B. in sogenannten Aerorädern verwendet, um die Aerodynamik zu verbessern. Dort sind sie unmittelbar neben Metalloberflächen, wie beispielsweise Leichtmetallen, angeordnet, welche häufig eine Oberflächenstruktur aufweisen, welche auf ein bestimmtes Herstellungsverfahren zurückzuführen ist. Beispielweise werden Leichtmetallfelgen häufig mittels eines Drehverfahrens hergestellt oder diesem zumindest als ein Herstellungsschritt unterzogen, welches eine deutlich sichtbare Oberflächenstruktur hervorruft. Derartige Oberflächenstrukturen sind häufig gewünscht, da sie den Eindruck einer besonders wertigen Herstellung vermitteln. Ein erfindungsgemäßer Radeinleger fügt sich in diese hochwertige Optik und Haptik unmittelbar ein, da aufgrund der Oberflächentextur einerseits und aufgrund der relativ dünnen Schichtdicke der metallischen Beschichtung andererseits die Optik und Haptik von z.B. Leichtmetall nachempfunden werden kann. Auf diese Weise erhält der Radeinleger eine im Vergleich zu Radeinlegern aus dem Stand der Technik wesentlich verbesserte Optik und Haptik.

Das erfindungsgemäße Formteil kann weiter eine Klarlackschicht aufweisen, welche die metallische Beschichtung zumindest teilweise bedeckt. Auf diese Weise ist es möglich, die Beschichtung vor äußeren Einflüssen zu schützen. Beispielweise kann der Klarlack vor mechanischen Einwirkungen, z.B. Steinschlag, oder Witterungseinflüssen schützen. Zumindest die vorteilhafte Optik des erfindungsgemäßen Formteils bleibt durch den Klarlack jedoch erhalten.

Die Erfindung ist grundsätzlich nicht auf Radeinleger beschränkt und umfasst auch andere Formteile, wie sie im Automobilbau, sowohl im Exterieur, als auch im Interieur, aber auch in anderen Industrien, wie z.B. Flugzeugbau, Möbelbau, Konsumgütern, Innenausbau, etc. verwendet werden.

Das erfindungsgemäße Formteil kann weiter eine zumindest teilweise über und/oder unter die metallische Beschichtung gespritzte Schicht transparenten Kunststoffs aufweisen. Auf diese Weise kann die metallische Schicht vor äußeren Einflüssen geschützt werden, ohne zumindest die im Vergleich zum Stand der Technik verbesserte Optik des Formteils zu beeinträchtigen.

Die Schicht transparenten Kunststoffs kann unmittelbar auf und/oder unter die metallische Beschichtung gespritzt ist. Hierdurch entfällt die Verwendung von Primern, Haftvermittlern oder ähnlichem. Die Oberflächentextur des Kunststoffsubstrats ist weiterhin fühl- und sichtbar.

Bei dem Kunststoffsubstrat kann es sich um einen transparenten Kunststoff handeln. Auf diese Weise ist die Oberflächentextur durch das Kunststoffsubstrat hindurch sichtbar.

Bei dem erfindungsgemäßen Formteil kann die metallische Schicht unmittelbar auf das Kunststoffsubstrat aufgebracht sein. Insbesondere kann sich zwischen der metallischen Schicht und dem Kunststoffsubstrat keine Zwischenschicht befinden. Weiter insbesondere kann sich zwischen der metallischen Schicht und dem Kunststoffsubstrat kein Primer befinden. Auf diese Weise wird die durch die Oberflächentextur des Kunststoffsubstrats hervorgerufene Optik und Haptik nicht beeinträchtigt. Aufgrund der erfindungsgemäß relativ dünnen metallischen Schicht kommt die Oberflächentextur unmittelbar zur Geltung. Das erfindungsgemäße Formteil kann somit den Eindruck eines metallisch bearbeiteten Teils vermitteln, wirkt hochwertig und fügt sich in unmittelbarer Nähe zu Metallteilen aus Vollmaterial optimal ein.

Der mittlere Abstand zwischen der dem Kunststoffsubstrat gegenüberliegenden Oberfläche der metallischen Beschichtung und dem Kunststoffsubstrat kann 0,1 bis 1,0 µm betragen. Bei der dem Kunststoffsubstrat gegenüberliegenden Oberfläche der metallischen Beschichtung handelt es sich um die Oberfläche, welche dem Kunststoffsubstrat abgewandt ist. Erfindungsgemäß kann ein derartig geringer Abstand zwischen der dem Kunststoffsubstrat abgewandten Oberfläche der metallischen Beschichtung und dem Kunststoffsubstrat dadurch erreicht werden, dass auf Zwischenschichten, wie z.B. Primer oder Haftvermittler verzichtet wird. Durch den geringen Abstand von 0,1 bis 1,0 µm bleibt die Oberflächentextur des darunterliegenden Kunststoffsubstrats sicht- und fühlbar.

Alternativ kann zwischen dem Kunststoffsubstrat und der metallischen Beschichtung eine im Verhältnis zur metallischen Schicht haftvermittelnde Zwischenschicht aufgebracht sein. Auf diese Weise kann die Haftung der metallischen Beschichtung verbessert werden. Die haftvermittelnde Zwischenschicht kann im Verhältnis zur metallischen Beschichtung dünn sein, so dass die vorteilhafte Optik und Haptik des erfindungsgemäßen Formteils nur soweit nötig beeinträchtigt wird. Die haftvermittelnde Zwischenschicht kann daher dünner sein als die metallische Beschichtung. Die haftvermittelnde Zwischenschicht kann außerdem weicher sein als die metallische Schicht.

Das Kunststoffsubstrat kann einer haftvermittelnden Oberflächenbehandlung unterzogen sein. Beispielsweise kann das Kunststoffsubstrat einer Corona-Behandlung, Plasma-Aktivierung, Beflammen, Aufrauen (z.B. mit Schleifpapier) oder durch Bestrahlen mit Sand, Trockeneis, Glasperlen unterzogen sein.

Die Zwischenschicht kann auf Zirkonium basieren. Zirkonium weist gute Hafteigenschaften auf und ist korrosionsbeständig.

Das Kunststoffsubstrat auf kann Polycarbonat, PC, oder Acrylnitril-Butadien-Styrol, ABS, basieren. Diese Materialien sind relativ einfach zu verarbeiten und langlebig.

Die Oberflächentextur des erfindungsgemäßen Formteils kann einer Textur mechanisch nachbearbeiteten Metalls nachempfunden sein. Auf diese Weise wirkt das Formteil hochwertig und wird selbst in unmittelbarer Nähe zu Metallteilen aus Vollmaterial nicht als Fremdkörper wahrgenommen. Beispiele für die Nachbearbeitung von Metall sind Schleifen, Fräsen, Hämmern, Sandstrahlen, Glasperlenstrahlen, Ätzen, etc.

Ein weiterer Aspekt der vorliegenden Erfindung betrifft ein Verfahren zur Herstellung eines Formteils, aufweisend die Schritte: (a.) Bereitstellen eines Kunststoffsubstrats, welches eine Oberflächentextur mit einer Tiefe 0,005 bis 0,2 mm aufweist; (b.) Beschichten des Kunststoffsubstrats mittels physikalischer Gasphasenabscheidung mit einer metallischen Beschichtung, welche die Oberflächentextur zumindest teilweise bedeckt und welche eine Dicke von 0,1 bis 1,0 µm aufweist.

Ein durch das erfindungsgemäße Verfahren hergestelltes Formteil weist gegenüber Formteilen im Stand der Technik eine wesentlich verbesserte Optik und Haptik auf. Aufgrund der relativ dünnen metallischen Beschichtung ist die darunterliegende Oberflächentextur des Kunststoffsubstrats sicht- und fühlbar. Diese fühl- und sichtbare Oberflächentextur kommt den Oberflächenstrukturen von Metallen, wie sie beispielsweise in Automobilen anzutreffen sind, so nahe, dass praktisch kein sicht- und fühlbarer Unterschied besteht. Ein durch das erfindungsgemäße Verfahren hergestellte Formteil wird daher insbesondere in unmittelbarer Nähe zu Metallteilen nicht als Fremdkörper empfunden.

Erfindungsgemäß ist die metallische Beschichtung im Vergleich zu gängigen Beschichtungen sehr dünn. Beispielweise beträgt die Schichtdicke von Lacken üblicherweise 25-40 µm. Die Schichtdicke von Chrom auf Kunststoff bewegt sich in einer ähnlichen Größenordnung. Durch die erfindungsgemäß geringe Schichtdicke der metallischen Beschichtung ist die darunterliegende Oberflächentextur des Kunststoffsubstrats sicht- und fühlbar. Dadurch kann die Oberflächenstruktur derjenigen von bearbeitetem Metall nachempfunden werden.

Ein weiterer Vorteil des erfindungsgemäßen Verfahrens besteht darin, dass das Kunststoffformteil - anders als Teile, die mittels Umformverfahren hergestellt werden - in nahezu beliebige Form gebracht werden kann. Beispielweise kann dieses mittels Spritzgussverfahren hergestellt werden, so dass nahezu beliebige Formen möglich sind. Trotzdem erhält das Formteil durch seine Oberflächentextur und die relativ dünne metallische Beschichtung ein wertiges Aussehen.

Die Tiefe der Oberflächentextur des Kunststoffsubstrats kann weiter bevorzugt 0,005 bis 0,1 mm betragen. Die Dicke der metallischen Beschichtung kann weiter bevorzugt 0,1 bis 0,6 µm betragen. Aufgrund der relativ geringen Dicke der metallischen Beschichtung kommt die Oberflächentextur selbst bei geringerer Tiefe zur Geltung.

Bei dem Formteil kann es sich um einen Radeinleger handeln. Wie bereits erläutert, werden Radeinleger z.B. in sogenannten Aerorädern verwendet, um die Aerodynamik zu verbessern. Dort sind sie unmittelbar neben Metalloberflächen, wie beispielsweise Leichtmetallen, angeordnet, welche häufig eine Oberflächenstruktur aufweisen, welche auf ein bestimmtes Herstellungsverfahren zurückzuführen ist. Beispielweise werden Leichtmetallfelgen häufig mittels eines Drehverfahrens hergestellt oder diesem zumindest als ein Herstellungsschritt unterzogen, welches eine deutlich sichtbare Oberflächenstruktur hervorruft. Derartige Oberflächenstrukturen sind häufig gewünscht, da sie den Eindruck einer besonders wertigen Herstellung vermitteln. Ein erfindungsgemäßer Radeinleger fügt sich in diese hochwertige Optik und Haptik unmittelbar ein, da aufgrund der Oberflächentextur einerseits und aufgrund der relativ dünnen Schichtdicke der metallischen Beschichtung andererseits die Optik und Haptik von z.B. Leichtmetall nachempfunden werden kann. Auf diese Weise erhält der Radeinleger eine im Vergleich zu Radeinlegern aus dem Stand der Technik wesentlich verbesserte Optik und Haptik.

Das erfindungsgemäße Verfahren kann weiter den Schritt des Aufbringens einer Klarlackschicht aufweisen, welche die metallische Beschichtung zumindest teilweise bedeckt. Auf diese Weise ist es möglich, die Beschichtung vor äußeren Einflüssen zu schützen. Beispielweise kann der Klarlack vor mechanischen Einwirkungen, z.B. Steinschlag, oder Witterungseinflüssen schützen. Zumindest die vorteilhafte Optik des erfindungsgemäßen Formteils bleibt durch den Klarlack jedoch erhalten.

Das erfindungsgemäße Verfahren kann weiter den Schritt des Überspritzens der metallischen Schicht zumindest teilweise mit einer Schicht transparenten Kunststoffs aufweisen. Auf diese Weise kann die metallische Schicht vor äußeren Einflüssen geschützt werden, ohne zumindest die im Vergleich zum Stand der Technik verbesserte Optik des Formteils zu beeinträchtigen.

Bei dem erfindungsgemäßen Verfahren kann die Schicht transparenten Kunststoffs unmittelbar auf die metallische Beschichtung gespritzt werden. Hierdurch entfällt die Verwendung von Primern, Haftvermittlern oder ähnlichem. Die Oberflächentextur des Kunststoffsubstrats ist weiterhin fühl- und sichtbar.

Bei dem erfindungsgemäßen Verfahren kann in Schritt b. die metallische Beschichtung unmittelbar auf das Kunststoffsubstrat aufgetragen werden. Insbesondere kann sich zwischen der metallischen Schicht und dem Kunststoffsubstrat keine Zwischenschicht befinden. Weiter insbesondere kann sich zwischen der metallischen Schicht und dem Kunststoffsubstrat kein Primer befinden. Auf diese Weise wird die durch die Oberflächentextur des Kunststoffsubstrats hervorgerufene Optik und Haptik nicht beeinträchtigt. Aufgrund der erfindungsgemäß relativ dünnen metallischen Schicht kommt die Oberflächentextur unmittelbar zur Geltung. Das erfindungsgemäße Formteil kann somit den Eindruck eines metallisch bearbeiteten Teils vermitteln, wirkt hochwertig und fügt sich in unmittelbarer Nähe zu Metallteilen aus Vollmaterial optimal ein.

Das erfindungsgemäße Verfahren kann weiter den Schritt des Aufbringens einer im Verhältnis zur metallischen Schicht haftvermittelnden Zwischenschicht zwischen dem Kunststoffsubstrat und der metallischen Schicht aufweisen. Auf diese Weise kann die Haftung der metallischen Beschichtung verbessert werden. Die haftvermittelnde Zwischenschicht kann im Verhältnis zur metallischen Beschichtung dünn sein, so dass die vorteilhafte Optik und Haptik des erfindungsgemäßen Formteils nur soweit nötig beeinträchtigt wird. Die haftvermittelnde Zwischenschicht kann daher dünner sein als die metallische Beschichtung. Die haftvermittelnde Zwischenschicht kann außerdem weicher sein als die metallische Schicht.

Bei dem erfindungsgemäßen Verfahren kann die Zwischenschicht auf Zirkonium basieren. Zirkonium weist gute Hafteigenschaften auf und ist korrosionsbeständig.

Das erfindungsgemäße Verfahren kann außerdem den Schritt einer haftvermittelnden Oberflächenbehandlung des Kunststoffsubstrats aufweisen. Beispielsweise kann das Kunststoffsubstrat einer Corona-Behandlung, Plasma-Aktivierung, Beflammen, Aufrauen (z.B. mit Schleifpapier) oder durch Bestrahlen mit Sand, Trockeneis, Glasperlen unterzogen werden. Hierdurch werden die Hafteigenschaften zur metallischen Beschichtung verbessert.

Bei dem erfindungsgemäßen Verfahren kann das Kunststoffsubstrat auf Polycarbonat, PC, oder Acrylnitril-Butadien-Styrol, ABS, basieren. Diese Materialien sind relativ einfach zu verarbeiten und langlebig.

Bei dem anspruchsgemäßen Verfahren kann die Oberflächentextur einer Textur mechanisch nachbearbeiteten Metalls nachempfunden werden. Auf diese Weise wirkt das Formteil hochwertig und wird selbst in unmittelbarer Nähe zu Metallteilen aus Vollmaterial nicht als Fremdkörper wahrgenommen. Beispiele für die Nachbearbeitung von Metall sind Schleifen, Fräsen, Hämmern, Sandstrahlen, Glasperlenstrahlen, Ätzen, etc.

### 4. Kurze Beschreibung der Figuren

- Fig. 1: zeigt einen Radeinleger als ein erfindungsgemäßes Ausführungsbeispiel;
- Fig. 2: zeigt einen vergrößerten Ausschnitt von Fig. 1; und
- Fig. 3: zeigt eine Detailansicht eines weiteren Ausführungsbeispiels der vorliegenden Erfindung.

### 5. Detaillierte Beschreibung bevorzugter Ausführungsbeispiele

Im Folgenden werden bevorzugt Ausführungsbeispiele der vorliegenden Erfindung anhand eines Radeinlegers für ein Automobil beschrieben. Die Erfindung ist jedoch nicht auf Radeinleger beschränkt, sondern umfasst beispielsweise auch andere Formteile, wie sie im Automobilbau, aber auch in anderen Industrien, wie z.B. Flugzeugbau, Möbelbau, Konsumgütern, Innenausbau, etc. verwendet werden. Die Erläuterungen zum Radeinleger gelten auch für das entsprechende Herstellungsverfahren.

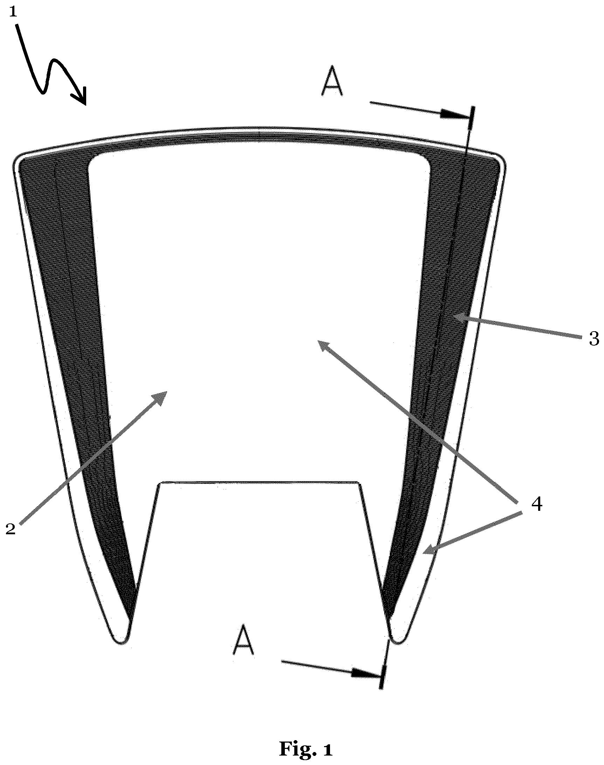

Fig. 1 zeigt ein Ausführungsbeispiel eines erfindungsgemäßen Formteils, nämlich einen sogenannten Radeinleger 1. Dabei handelt es sich um Abdeckungen oder Blenden, welche die Aerodynamik des Rades verbessern. Die Abdeckungen sind häufig am Rand der Felge angeordnet, da sie dort ihre größte Wirkung entfalten. Der Radeinleger 1 wird zwischen den Speichen einer Felge angeordnet, z.B. festgeklemmt. Der Radeinleger weist ein Kunststoffsubstrat 2 auf. Dieses kann z.B. mittels eines Spritzgussverfahrens hergestellt werden. Beispielhaft Kunststoffe für das Kunststoffsubstrat 2 sind Polycarbonat (PC) und Acrylnitril-Butadien-Styrol (ABS).

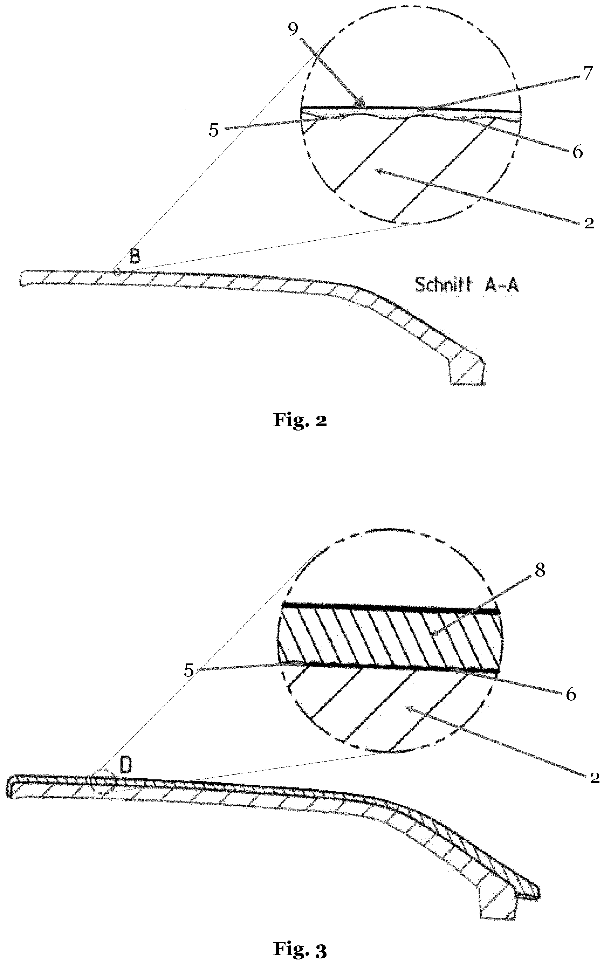

In dem Ausführungsbeispiel der Fig. 1 weist das Kunststoffsubstrat 2 einen beschichteten Bereich 3 und einen unbeschichteten Bereich 4 auf. Der Schnitt längs der Achse A-A durch den beschichteten Bereich ist in der Fig. 2 gezeigt. Wie in dem in Fig. 2 gezeigten Detailausschnitt dargestellt ist, weist das Kunststoffsubstrat 2 eine Oberflächentextur 5 auf. Diese weist erfindungsgemäß eine Tiefe von 0,005 bis 0,2 mm auf. Unter der Tiefe der Textur 5 ist der durchschnittliche Abstand von höchster zu tiefster Erhebung der Oberfläche orthogonal zur Oberfläche zu verstehen. Die Oberflächentextur 5 kann beispielsweise beim Spritzgießen des Kunststoffsubstrats in dieses eingebracht werden. Beispielsweise kann dazu die Gussform z.B. mit einem Laser so bearbeitet werden, dass die Gussform das Negativ der Oberflächentextur 5 erhält. Beim Spritzgießen bildet sich entsprechend das gewünschte Positiv in der Oberfläche des Kunststoffsubstrats ab.

Die Oberflächentextur 5 kann einer Textur mechanisch nachbearbeiteten Metalls nachempfunden sein. Auf diese Weise wirkt das Formteil 1 hochwertig und wird selbst in unmittelbarer Nähe zu Metallteilen aus Vollmaterial nicht als Fremdkörper wahrgenommen. Beispiele für die Nachbearbeitung von Metall sind Schleifen, Fräsen, Hämmern, Sandstrahlen, Glasperlenstrahlen, Ätzen, etc.

Der beschichtete Bereich 3 weist außerdem eine metallische Beschichtung 6 auf. Diese ist im Ausführungsbeispiel unmittelbar auf das Kunststoffsubstrat 2, bzw. die Oberflächentextur 5 aufgebracht, d.h. zwischen metallischer Beschichtung 6 und dem Kunststoffsubstrat 2 befindet sich kein weiteres Material wie z.B. ein Primer oder Haftvermittler. Der mittlere Abstand zwischen der dem Kunststoffsubstrat 2 gegenüberliegenden Oberfläche 9 der metallischen Beschichtung 6 und dem Kunststoffsubstrat 2 entspricht dann der Dicke der metallischen Beschichtung, also 0,1 bis 1,0 µm. Bei der dem Kunststoffsubstrat 2 gegenüberliegenden Oberfläche der metallischen Beschichtung 6 handelt es sich um die Oberfläche, welche dem Kunststoffsubstrat 2 abgewandt ist.

In anderen Ausführungsbeispielen kann zwischen metallischen Beschichtung 6 und dem Kunststoffsubstrat 2 eine Zwischenschicht, z.B. aus Zirkonium, verwendet werden.

Die metallische Beschichtung 6 ist mittels eines Dünnschichtverfahrens aufgetragen, insbesondere einem physikalischen Gasphasenabscheidungsverfahren (Physical Vapor Deposition, PVD). Hierbei handelt es sich um ein in der Regel vakuumbasiertes Beschichtungsverfahren (auch als Dünnschichttechnologie bezeichnet). Dabei wird das Ausgangsmaterial, erfindungsgemäß Metall, in die Gasphase überführt. Das gasförmige Material wird anschließend zum zu beschichtenden Substrat geführt, wo es kondensiert und die Zielschicht bildet. Beispielhafte Metalle im Rahmen der vorliegenden Erfindung sind Aluminium, Chrom, Eisen, Kupfer, etc.

Von Dünnschichtverfahren spricht man üblicherweise, wenn die aufgetragene Schicht dünner als 5 µm ist. Andere geeignete Dünnschichtverfahren (außer dem genannten PVD-Verfahren) im Rahmen der vorliegenden Erfindung sind chemische Gasphasenabscheidung und plasmaunterstützte chemische Gasphasenabscheidung.

Im Ausführungsbeispiel der Fig. 1 beträgt die Dicke der metallischen Beschichtung 0,1 bis 1,0 µm. Die metallische Beschichtung 6 ist im Bereich 3 auf das Kunststoffsubstrat 2 aufgetragen und bedeckt diese in diesem Bereich, nicht jedoch im Bereich 4. Hierzu können z.B. geeignete Masken während des PVD-Beschichtens verwendet werden.

Über der metallischen Beschichtung 6 ist im Ausführungsbeispiel der Figuren 1 und 2 ein Schutzlack 7 aufgebracht. Hierbei handelt es sich um eine optionale Schutzschicht. Beispielsweise kann hierfür ein Klarlack verwendet werden.

Fig. 3 zeigt ein weiteres Ausführungsbeispiel der vorliegenden Erfindung anhand eines Radeinlegers. Bei der Fig. 3 handelt es sich - ähnlich wie bei der Fig. 2-um eine Schnittdarstellung. Auch hier ist auf einem Kunststoffsubstrat 2 eine metallische Beschichtung 6 aufgetragen. Das Kunststoffsubstrat 2 weist eine Oberflächentextur mit einer Tiefe von 0,005 bis 0,2 mm auf. Die metallische Beschichtung 6 ist mittels Dünnschichtverfahren, und im speziellen physikalischer Gasphasenabscheidung (Physical Vapor Deposition, PVD), aufgebracht und bedeckt die Oberflächentextur 5 zumindest teilweise. Die metallische Beschichtung weist eine Dicke von 0,1 bis 1,0 µm auf. Zusätzlich ist über der metallischen Beschichtung 6 eine transparente Kunststoffkomponente 8 angeordnet. Diese kann beispielsweise mittels eines Spritzgussverfahrens über die metallische Beschichtung 6 gespritzt werden. Dadurch, dass die Komponente 8 transparent ist, ist die darunterliegende metallische Beschichtung 6 und insbesondere die Oberflächentextur 5 des Kunststoffsubstrats 2 unter der metallischen Beschichtung 6 sichtbar. Dies ist möglich, da erfindungsgemäß die metallischen Beschichtung 6 relativ dünn ist.

Bei einem alternativen Herstellungsverfahren für das in Fig. 3 gezeigte Formteil 1 wird zuerst die transparente Komponente 8 gespritzt und mit einer Oberflächentextur 5 von 0,005 mm bis 0,2 mm Tiefe versehen. Anschließend wird die transparente Komponente 8 zumindest teilweise mit einer metallischen Beschichtung 6 von 0,1 µm bis 1,0 µm Dicke versehen. Vorzugsweise wird die metallische Beschichtung 6 unmittelbar, d.h. ohne Zwischenschicht wie z.B. Haftvermittler oder Primer, auf die Oberflächentextur 5 aufgebracht. Die metallische Beschichtung 6 kann dann abgedichtet werden, z.B. mittels einer angespritzten Kunststoffschicht 2 oder einem Klarlack. In anderen Ausführungsbeispielen wird auf eine Abdichtung verzichtet.

## Patentansprüche

1. Formteil, aufweisend:
a. zumindest ein Kunststoffsubstrat, welches eine Oberflächentextur mit einer Tiefe von 0,005 bis 0,2 mm aufweist; und
b. eine auf das Kunststoffsubstrat mittels Dünnschichtverfahren, im speziellen physikalischer Gasphasenabscheidung (Physical Vapor Deposition, PVD), aufgebrachte metallische Beschichtung, welche die Oberflächentextur zumindest teilweise bedeckt und welche eine Dicke von 0,1 bis 1,0 µm aufweist.

2. Formteil nach Anspruch 1, wobei es sich bei dem Formteil um einen Radeinleger handelt.

3. Formteil nach einem der Ansprüche 1 oder 2, weiter aufweisend eine Klarlackschicht, welche die metallische Beschichtung zumindest teilweise bedeckt.

4. Formteil nach einem der Ansprüche 1 bis 3, weiter aufweisend eine zumindest teilweise über und/oder unter die metallische Beschichtung gespritzte Schicht transparenten Kunststoffs.

5. Formteil nach Anspruch 4, wobei die Schicht transparenten Kunststoffs unmittelbar auf und/oder unter die metallische Beschichtung gespritzt ist.

6. Formteil nach einem der Ansprüche 1-5, wobei die metallische Beschichtung unmittelbar auf das Kunststoffsubstrat aufgebracht ist.

7. Formteil nach einem der Ansprüche 1-5, wobei zwischen dem Kunststoffsubstrat und der metallischen Schicht eine im Verhältnis zur metallischen Schicht haftvermittelnde Zwischenschicht aufgebracht ist.

8. Formteil nach Anspruch 7, wobei die Zwischenschicht auf Zirkonium basiert.

9. Formteil nach einem der Ansprüche 1-8, wobei das Kunststoffsubstrat auf Polycarbonat, PC, oder Acrylnitril-Butadien-Styrol, ABS, basiert.

10. Formteil nach einem der Ansprüche 1-9, wobei die Oberflächentextur einer Textur mechanisch nachbearbeiteten Metalls nachempfunden ist.

11. Verfahren zur Herstellung eines Formteils, aufweisend die Schritte:
a. Bereitstellen eines Kunststoffsubstrats, welches eine Oberflächentextur mit einer Tiefe 0,005 bis 0,2 mm aufweist;
b. Beschichten des Kunststoffsubstrats mittels physikalischer Gasphasenabscheidung mit einer metallischen Beschichtung, welche die Oberflächentextur zumindest teilweise bedeckt und welche eine Dicke von 0,1 bis 1,0 µm aufweist.

12. Verfahren nach Anspruch 11, wobei es sich bei dem Formteil um einen Radeinleger handelt.

13. Verfahren nach einem der Ansprüche 11 oder 12, weiter aufweisend den Schritt des Aufbringens einer Klarlackschicht, welche die metallische Beschichtung zumindest teilweise bedeckt.

14. Verfahren nach einem der Ansprüche 11 oder 12, weiter aufweisend den Schritt des Überspritzens der metallischen Schicht zumindest teilweise mit einer Schicht transparenten Kunststoffs.

15. Verfahren nach Anspruch 14, wobei die Schicht transparenten Kunststoff unmittelbar auf die metallische Beschichtung gespritzt wird.

16. Verfahren nach einem der Ansprüche 11-15, wobei in Schritt b. die metallische Beschichtung unmittelbar auf das Kunststoffsubstrat aufgetragen wird.

17. Verfahren nach einem der Ansprüche 11-15, weiter aufweisend den Schritt des Aufbringens einer im Verhältnis zur metallischen Schicht haftvermittelnden Zwischenschicht zwischen dem Kunststoffsubstrat und der metallischen Schicht.

18. Verfahren nach Anspruch 17, wobei die Zwischenschicht auf Zirkonium basiert.

19. Verfahren nach einem der Ansprüche 11-18, wobei das Kunststoffsubstrat auf Polycarbonat, PC, oder Acrylnitril-Butadien-Styrol, ABS, basiert.

20. Verfahren nach einem der Ansprüche 11-19, wobei die Oberflächentextur einer Textur mechanisch nachbearbeiteten Metalls nachempfunden wird.
